# FASCICULE DE BREVET EUROPEEN

(11) **EP 0 441 713 B1**
(45) Date de publication et mention de la délivrance du brevet: **07.04.1993**
(21) Numéro de dépôt: 91400315.7
(22) Date de dépôt: 08.02.1991
(51) Int. Cl.: H01L 31/0232, E05B 49/00, H01L 25/04

(54) **Système de télécommande en particulier pour le verrouillage/déverrouillage des ouvrants de véhicules automobiles**
Fernsteuerungssystem, insbesondere zum Schliessen/Öffnen von Autotüren
Remote control system, particularly to lock/unlock car doors

(30) Priorité: 09.02.1990 FR 9001541
(43) Date de publication de la demande: 14.08.1991
(73) Titulaire: VALEO NEIMAN, 78290 Croissy-sur-Seine (FR)
(72) Inventeur: Rydel, Charles, F-75019 Paris (FR)
(74) Mandataire: Schrimpf, Robert

(56) Documents cités:
- DE-A- 2 440 168
- DE-A- 3 803 541
- IBM TECHNICAL DISCLOSURE BULLETIN, vol. 29, no. 2, juillet 1986, pages 802-805, New York, US; "Optical dispersion plate"
- PATENT ABSTRACTS OF JAPAN, vol. 5, no. 176 (E-81)[848], 12 novembre 1981; & JP-A-56 103 481 (FUJI SHASHIN FILM K.K.) 18-08-1981
- PATENT ABSTRACTS OF JAPAN, vol. 13, no. 499 (P-957)[3847], 10 novembre 1989; & JP-A-1 200 221 (MINOLTA CAMERA CO., LTD) 11-08-1989

## Description

La présente invention concerne le domaine des systèmes de télécommande, notamment par liaison infrarouge.

La présente invention s'applique tout particulièrement aux systèmes de télécommande pour le verrouillage et le déverrouillage de portières de véhicules automobiles.

Les systèmes de télécommande connus comprennent généralement un émetteur portatif comportant des moyens formant source de lumière aptes à générer un flux lumineux codé et un récepteur fixe comportant des moyens photo-sensibles conçus pour recevoir le flux lumineux précité et associés à des moyens de traitement conçus pour décoder celui-ci. Un tel système de télécommande est décrit dans la demande de brevet DE-A-3803541.

La présente invention a pour but principal de proposer de nouveaux moyens permettant de perfectionner le récepteur en permettant une détection du flux lumineux codé sur 360°, c'est-à-dire pratiquement quelle que soit la direction d'incidence de celui-ci.

Selon la présente invention, le système de télécommande est caractérisé par le fait que les moyens photo-sensibles du récepteur comprennent une lentille d'enveloppe extérieure asphérique toroïdale associée à différentes cellules photo-sensibles.

D'autres caractéristiques, buts et avantages de la présente invention apparaîtront à la lecture de la description détaillée qui va suivre, et en regard des dessins annexés, donnés à titre d'exemples non limitatifs, et sur lesquels :
- la figure 1 représente schématiquement un système de télécommande pour le verrouillage/déverrouillage de portières de véhicules automobiles conforme à la présente invention,
- la figure 2 représente une vue schématique de dessus des moyens photo-sensibles conformes à la présente invention,
- la figure 3 représente une vue partielle en coupe verticale d'une lentille asphérique toroïdale conforme à la présente invention,
- les figures 4, 5, 6, 7, 8 et 9 représentent six spots diagrammes illustrant le flux lumineux reçu par les cellules photo-sensibles selon diverses incidences horizontales et verticales,
- les figures 10 et 11 représentent schématiquement en coupe verticale deux autres variantes de réalisation de la lentille asphérique toroïdale conforme à la présente invention.

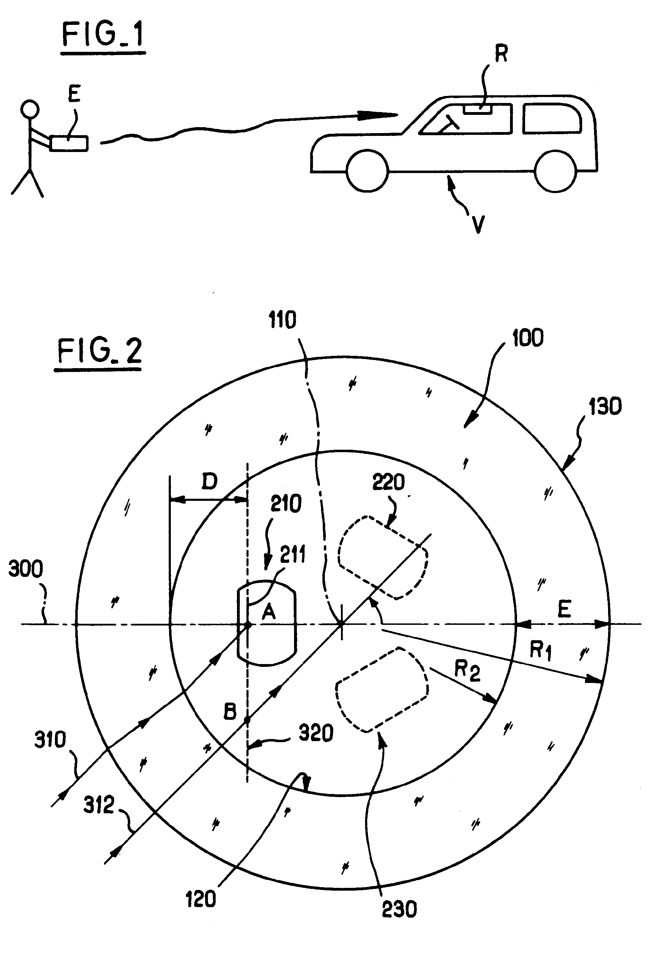

On a représenté schématiquement sur la figure 1 annexée, un système de télécommande conforme à la présente invention conçu pour assurer le verrouillage/déverrouillage à distance des portières d'un véhicule automobile V. Ce système comprend un émetteur E et un récepteur R.

L'émetteur E est placé dans un boîtier portatif. Il est conçu pour générer une onde électromagnétique codée, le plus souvent un rayonnement infrarouge.

Le récepteur R est placé dans le véhicule V. Il est conçu pour recevoir et décoder le signal généré par l'émetteur E.

Lorsque le signal reçu par le récepteur R correspond à un code prédéterminé, le récepteur R contrôle le verrouillage/déverrouillage respectivement des portières du véhicule automobile.

De nombreux systèmes émetteur et récepteur ont déjà été proposés à cette fin.

Pour cette raison, la structure de l'émetteur E et du récepteur R ne sera pas décrite en détail par la suite.

Dans le cadre de la présente demande de brevet on se contentera de décrire les moyens photo-sensibles conformes à l'invention intégrés au récepteur R.

Pour l'essentiel, ces moyens photo-sensibles comprennent une lentille asphérique toroïdal 100 associée à différentes cellules photo-sensibles 210, 220, 230.

La lentille 100 possède un axe de symétrie 110 vertical à l'utilisation.

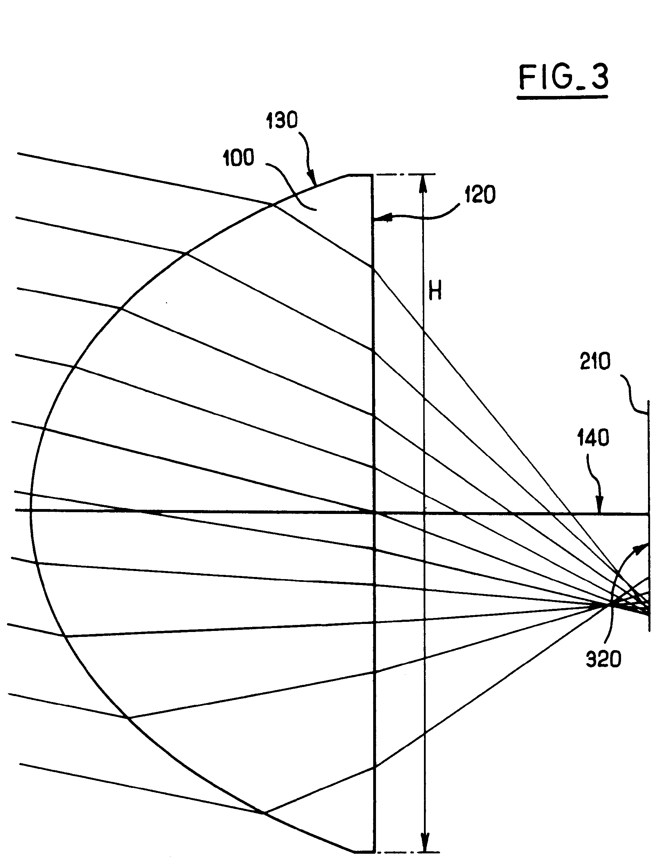

Plus précisément, selon le mode de réalisation représenté sur les figures 2 et 3, la lentille 100 est délimitée par une surface interne 120 et une surface externe 130.

La surface interne 120 est cylindrique de révolution autour de l'axe 110. C'est-à-dire que la surface interne 120 est délimitée par une génératrice parallèle à l'axe 110, de révolution autour de celui-ci.

La surface externe 130 est asphérique de révolution autour de l'axe 110. De préférence, il est prévu, sur l'intérieur de la surface interne 120 trois cellules 210, 220, 230 équiréparties à 120° autour de l'axe 110 comme représenté sur la figure 2, ou quatre cellules photo-sensibles équivalentes équiréparties à 90° autour de l'axe 110.

A titre d'exemple non limitatif, les cellules photo-sensibles peuvent être du type BPW46. De telles cellules ont une surface sensible couvrant à peu près un champ de 3x3mm.

De préférence la lentille asphérique toroïdale 100 est réalisée par moulage de matière plastique, en une seule pièce.

Selon un mode de réalisation particulier, la lentille 100 est réalisée en acrylique moulé. Son indice à une longueur d'onde de 0,9µm est de 1,485. La lentille 100 est un tore à 360° présentant un diamètre externe R1 de l'ordre de 28mm, considéré dans le plan de symétrie de la lentille transversale à l'axe 110. La section droite verticale de la lentille 100 est plan-elliptique comme représenté sur la figure 3 et comme précédemment décrit.

L'épaisseur E de la lentille correspondant à la différence entre le rayon R1 externe précité et le rayon R2 de la surface interne 120 est de l'ordre de 5mm.

La hauteur H de la lentille 100, considérée parallèlement à l'axe 110 est de l'ordre de 10mm. La surface extérieure elliptique 130 présente en outre les caractéristiques suivantes : rayon de courbure : 3,6mm, paramètre d'asphérisation : -0,6, et hauteur utile par rapport à l'axe : 5mm. La focale résultante d'une telle lentille est de l'ordre de 7,4227mm.

Les cellules 210, 220 et 230 représentées schématiquement sur la figure 2, ont leur surface photo-sensible située sur le plan de moindre diffusion à une distance D=4mm de la surface interne 120 de la lentille.

On a représenté sur la figure 2 sous la référence 300 un axe de visé perpendiculaire à la surface sensible 211 de la cellule 210. Cet axe de visé 300, horizontal à l'utilisation passe par le plan de symétrie de la lentille 100 qui est perpendiculaire à l'axe 110.

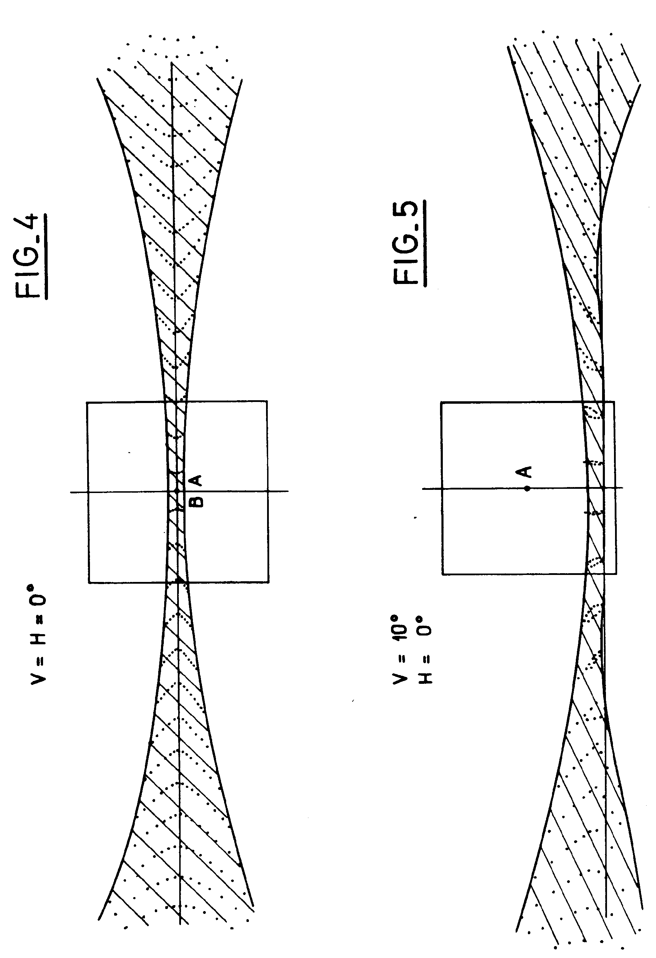

On a également représenté sur la figure 2 sous la référence 310, 312 deux rayons lumineux ayant une incidence horizontale de 45° par rapport à l'axe de visé 300 précité. C'est-à-dire que les deux rayons lumineux 310, 312 sont contenus dans le plan de symétrie horizontal de la lentille 100 perpendiculaire à l'axe vertical 110, mais que leur incidence est incliné de 45° par rapport à l'axe de visé 300. Le rayon 310 arrive au centre A de la surface photo-sensible 211 de la cellule 210. Le rayon 312 passe par le centre de la lentille, c'est-à-dire par le point d'intersection de l'axe vertical 110 et de l'axe de visé théorique horizontal 300. Le rayon 312 n'est par conséquent pas dévié lors de la traversée de la lentille 100. Le rayon 312 coupe le plan de mise au point 320, qui passe par la surface photo-sensible 211, en B. Les points A et B sont repérés sur les spots diagrammes représentés sur les figures 4 à 9.

Sur la figure 3 on a représenté un faisceau de rayon méridien ayant une incidence de 10° par rapport au plan de symétrie 140 de la lentille transversale à l'axe 110.

Les spots diagrammes représentés sur les figures 4 à 9 ont été réalisés dans les conditions suivantes.

Le plan de mise au point était situé à 4mm de la surface interne 120 de la lentille asphérique toroïdale. La pupille considérée était rectangulaire de 10x20mm.

La figure 4 correspond au cas d'un faisceau présentant une incidence azimutale H et une incidence zénithale V nulles, c'est-à-dire un faisceau coïncidant avec l'axe de visé 300.

La figure 5 correspond au cas d'un faisceau présentant une incidence azimutale H nulle mais une incidence zénithale V de 10°, c'est-à-dire un faisceau contenu dans un plan vertical passant par l'axe 110 mais incliné de 10° par rapport à l'axe de visé 300.

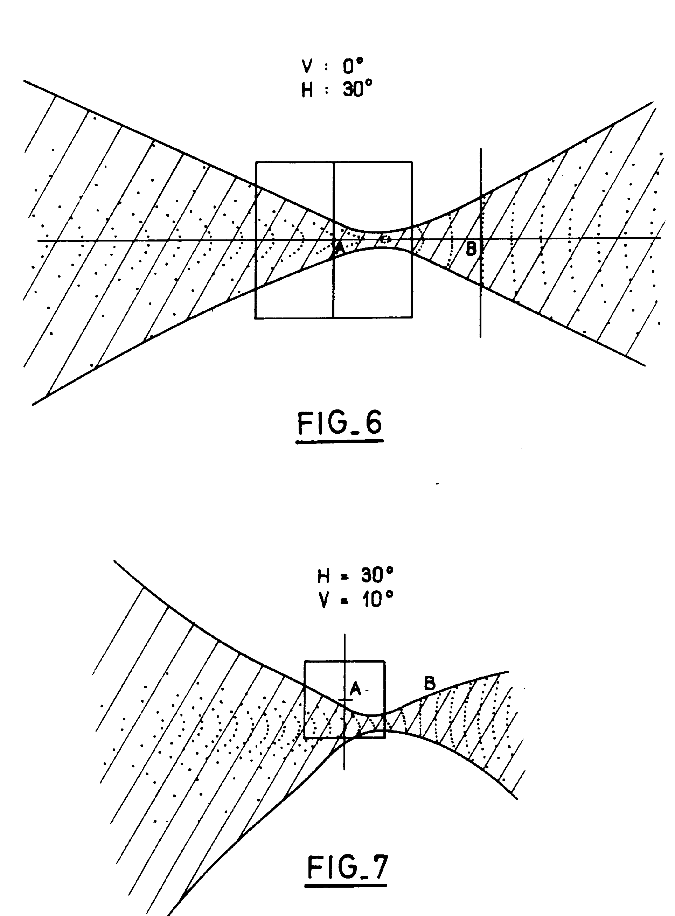

La figure 6 correspond au cas d'un faisceau présentant une incidence azimutale H de 30° et une incidence zénithale V nulle, c'est-à-dire un faisceau contenu dans le plan de symétrie 140 de la lentille, transversal à l'axe 110, mais incliné de 30° par rapport à l'axe de visé 300.

La figure 7 correspond au cas d'un faisceau présentant une incidence azimutale H de 30° et une incidence zénithale V de 10°.

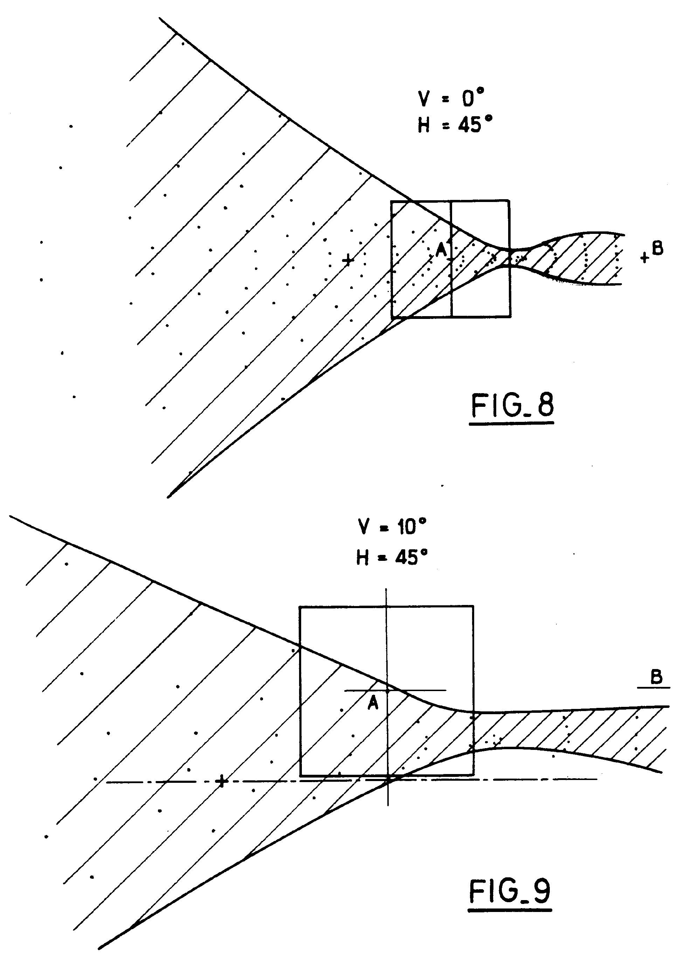

La figure 8 correspond au cas d'un faisceau présentant une incidence azimutale H de 45° et une incidence zénithale V nulle.

Enfin, la figure 9 correspond au cas d'un faisceau présentant une incidence azimutale H de 45° et une incidence zénithale V de 10°.

Les figures 4 et 5 montrent une perte de lumière quasi-nulle. Il en est de même pour la figure 6. La perte de lumière est très faible dans le cas de la figure 7. La perte de lumière est également nulle dans le cas de la figure 8 et très faible dans le cas de la figure 9.

Les tracés des figures 4 à 9 montrent qu'au moins jusqu'à 45° de l'axe, la lentille asphérique toroïdale 100 permet de récupérer quasi-totalement le flux incident sur les cellules photo-sensibles 200.

Bien entendu, l'invention n'est pas limitée aux modes de réalisation particuliers précédemment décrits, mais s'étend à toutes variantes conformes à son esprit.

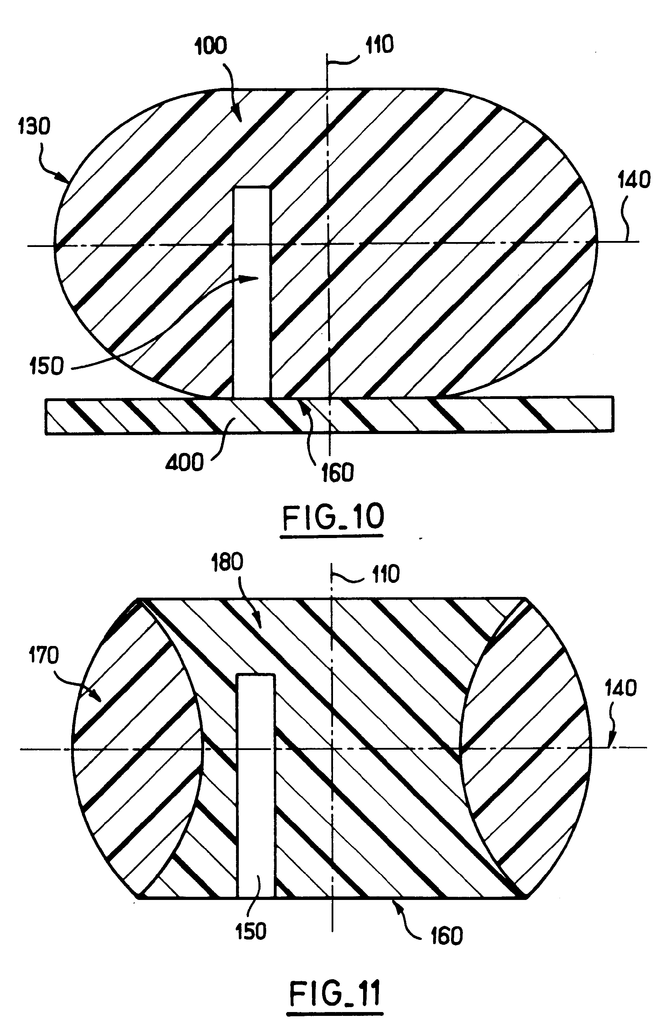

Par exemple, comme représenté sur la figure 10 annexée, la lentille asphérique toroïdale 100 peut être pleine. Sa surface extérieure 130 peut rester conforme aux caractéristiques précédemment indiquées. Cependant, le bloc centré sur l'axe 110 possède alors une pluralité d'alésages 150 équarépartis autour de l'axe 110 pour recevoir les cellules photo-sensibles 210, 220, 230. Ces alésages 150 débouchent sur une face 160 de la lentille qui s'étend transversalement à l'axe 110. Cette face 160 est adjacente à une plaquette 400 servant au support des cellules photo-sensibles. Les cellules photo-sensibles sont ainsi glissées dans les alésages 150. On peut prévoir de réaliser les alésages 150 juste complémentaires de l'enveloppe externe des cellules photo-sensibles 210, 220, 230.

On peut encore prévoir de réaliser les alésages 150 avec des sections supérieures à celles des cellules photo-sensibles 210, 220, 230 et d'immobiliser ces dernières dans les alésages 150 à l'aide de résine durcissable ou d'huile silicone présentant de préférence un indice très proche de celui de la lentille 100.

La réalisation de la lentille 100 sous forme d'une lentille asphérique toroïdale pleine permet d'assurer un positionnement automatique fiable et précis des cellules photo-sensibles 210, 220, 230.

Selon encore une autre variante, représentée schématiquement sur la figure 11, la lentille asphérique toroïdale 100 peut être formée par l'association de différents éléments concentriques, par exemple deux éléments concentriques 170, 180 schématiquement représentés sur la figure 11, formés de matériaux plastiques différents.

Il peut s'agir par exemple de polystyrène et de polyméthylméthacrylate.

L'utilisation d'une lentille formée de différents éléments concentriques en matériaux différents, permet une correction de diverses aberrations, de façon connue en soi.

## Revendications

1. Système de télécommande, notamment pour le verrouillage et le déverrouillage de portières de véhicules automobiles, du type comprenant un émetteur portatif comportant des moyens formant source de lumière aptes à générer un flux lumineux codé et un récepteur fixe comportant des moyens photo-sensibles conçus pour recevoir le flux lumineux et associés à des moyens de traitements conçus pour décoder celui-ci, caractérisé par le fait que les moyens photo-sensibles du récepteur comprennent une lentille ( 100) d'enveloppe extérieure asphérique toroïdale entourant différentes cellules photo-sensibles (210, 220, 230).

2. Système de télécommande selon la revendication 1, caractérisé par le fait que le récepteur comprend trois cellules (210, 220, 230) équiréparties à 120°.

3. Système de télécommande selon la revendication 1, caractérisé par le fait que le récepteur comprend quatre cellules équiréparties à 90°.

4. Système de télécommande selon l'une des revendications 1 à 3, caractérisé par le fait que la lentille (100) est délimitée par une surface interne (120) cylindrique de révolution autour d'un axe vertical (110) et par une enveloppe externe (130) asphérique toroïdale de révolution autour de l'axe (110).

5. Système de télécommande selon l'une des revendications 1 à 3, caractérisé par le fait que la lentille (100) d'enveloppe extérieure asphérique toroïdale est pleine et pourvue de différents alésages (150) conçus pour recevoir les cellules photo-sensibles (210, 220, 230) et débouchant sur une face latérale de la lentille transversale à son axe de symétrie (110).

6. Système de télécommande selon l'une des revendications 1 à 5, caractérisé par le fait que la lentille (100) asphérique toroïdale est réalisée par moulage de matières plastiques.

7. Système de télécommande selon l'une des revendications 1 à 6, caractérisé par le fait que la lentille (100) asphérique toroïdale est réalisée en acrylique.

8. Système de télécommande selon l'une des revendications 1 à 7, caractérisé par le fait que la surface extérieure (130) asphérique toroïdale de la lentille (100) présente un rayon de courbure de 3,6 mm et un paramètre d'asphérisation de -0,6.

9. Système de télécommande selon l'une des revendications 1 à 8, caractérisé par le fait que la lentille (100) est réalisée à l'aide de différents éléments ( 170, 180) concentriques.

10. Système de télécommande selon l'une des revendications 1 à 9, caractérisé par le fait que la lentille (100) est réalisée à l'aide de deux éléments ( 170, 180) concentriques formées respectivement de polystyrène et de polyméthylméthacrylate.

## Patentansprüche

1. Fernsteuerungssystem, insbesondere zum Schließen und Öffnen von Autotüren, enthaltend einen tragbaren Sender mit Mitteln, die als Lichtquelle dienen und geeignet sind, einen codierten Lichtstrom zu erzeugen, sowie einen fest eingebauten Empfänger mit lichtempfindlichen Mitteln, die aufgrund ihrer Konstruktion zum Empfang des Lichtstroms geeignet und mit Verarbeitungsmitteln verbunden sind, die dessen Decodierung zulassen, **dadurch gekennzeichnet,** daß die lichtempfindlichen Mittel des Empfängers eine torische, asphärische Außenumhüllungslinse (100) einschließen, die mehrere Fotozellen (210, 220, 230) umgibt.

2. Fernsteuerungssystem nach Anspruch 1, **dadurch gekennzeichnet,** daß der Empfänger drei im gleichen bestand von 120° angeordnete Zellen (210, 220, 230) enthält.

3. Fernsteuerungssystem nach Anspruch 1, **dadurch gekennzeichnet,** daß der Empfänger vier im gleichen bestand von 90° angeordnete Zellen enthält.

4. Fernsteuerungssystem nach einem der Ansprüche 1 bis 3, **dadurch gekennzeichnet,** daß die Linse (100) durch eine zylindrische, um eine vertikale Achse (110) rotierende Innenfläche (120) und durch eine um die Achse (110) rotierende torische, asphärische Außenhülle (130) begrenzt wird.

5. Fernsteuerungssystem nach einem der Ansprüche 1 bis 3, **dadurch gekennzeichnet**, daß die torische, asphärische Außenumhüllungslinse (100) massiv und mit mehreren Bohrungen (150) versehen ist, die aufgrund ihrer Auslegung zur Aufnahme der Fotozellen (210, 220, 230) geeignet sind und in einer quer zur Symmetrieachse (110) verlaufenden Seitenfläche der Linse münden.

6. Fernsteuerungssystem nach einem der Ansprüche 1 bis 5, **dadurch gekennzeichnet,** daß die torische, asphärische Linse (100) aus Kunststoffen geformt ist.

7. Fernsteuerungssystem nach einem der Ansprüche 1 bis 6, **dadurch gekennzeichnet,** daß die torische, asphärische Linse (100) aus Acryl besteht.

8. Fernsteuerungssystem nach einem der Ansprüche 1 bis 7, **dadurch gekennzeichnet,** daß die torische, asphärische Außenfläche (130) der Linse (100) einen Krümmungshalbmesser von 3,6 mm und einen Asphärisierungsparameter von -0,6 aufweist.

9. Fernsteuerungssystem nach einem der Ansprüche 1 bis 8, **dadurch gekennzeichnet,** daß die Linse (100) aus mehreren konzentrischen Elementen (170, 180) besteht.

10. Fernsteuerungssystem nach einem der Ansprüche 1 bis 9, **dadurch gekennzeichnet,** daß die Linse (100) aus zwei konzentrischen Elementen (170, 180) besteht, die sich jeweils aus Polystyrol und Polymethylmethacrylat zusammensetzen.

## Claims

1. A remote control system, in particular for locking and unlocking the doors of a motor vehicle, the system being of the type comprising a portable transmitter including means constituting a light source suitable for generating an encoded light flux, and a fixed receiver including photosensitive means designed to receive the light flux and associated with treatment means designed to decode it, the system being characterized by the fact that the photosensitive means of the receiver comprise a lens (100) having a toroidal aspherical outside surface surrounding a plurality of photocells (210,220,230).

2. A remote control system according to claim 1, characterized by the fact that the receiver includes three photocells (210,220,230) uniformly spaced apart at 120° intervals.

3. A remote control system according to claim 1, characterized by the fact that the receiver includes four photocells uniformly spaced apart at 90° intervals.

4. A remote control system according to any one of claims 1 to 3, characterized by the fact that the lens (100) is delimited by an inside surface (120) in the form of a circular cylinder about a vertical axis (110) and by a toroidal aspherical outside surface (130), thereby constituting a body of revolution about the axis (110).

5. A remote control system according to any one of claims 1 to 3, characterized by the fact that the lens (100) having a toroidal aspherical outside surface is solid and is provided with a plurality of slots (150) designed to receive the photosensitive cells (210,220,230), said slots opening out into a lateral face of the lens extending transversely to its axis of symmetry (110).

6. A remote control system according to any one of claims 1 to 5, characterized by the fact that the toroidal aspherical lens (100) is made by molding plastic.

7. A remote control system according to any one of claims 1 to 6, characterized by the fact that the toroidal aspherical lens (100) is made of acrylic.

8. A remote control system according to any one of claims 1 to 7, characterized by the fact that the toroidal aspherical outside surface (130) of the lens (100) has a radius of curvature of 3.6 mm and an aspherical parameter of -0.6.

9. A remote control system according to any one of claims 1 to 8, characterized by the fact that the lens (100) is made up of a plurality of concentric parts (170,180).

10. A remote control system according to any one of claims 1 to 9, characterized by the fact that the lens (100) is made up of two concentric parts (170,180) made respectively of polystyrene and of polymethylmethacrylate.
